(19) Europäisches Patentamt
European Patent Office
Office européen des brevets

(11) **EP 1 398 817 A2**

(12) **EUROPÄISCHE PATENTANMELDUNG**

(43) Veröffentlichungstag:
**17.03.2004 Patentblatt 2004/12**

(51) Int Cl.⁷: **H01J 37/147**

(21) Anmeldenummer: **03017789.3**

(22) Anmeldetag: **04.08.2003**

(84) Benannte Vertragsstaaten:
**AT BE BG CH CY CZ DE DK EE ES FI FR GB GR HU IE IT LI LU MC NL PT RO SE SI SK TR**
Benannte Erstreckungsstaaten:
**AL LT LV MK**

(30) Priorität: **02.08.2002 DE 10235455**

(71) Anmelder: **LEO Elektronenmikroskopie GmbH**
**73447 Oberkochen (DE)**

(72) Erfinder: **Clauss, Wilfried**
**73447 Oberkochen (DE)**

(74) Vertreter: **Schorr, Frank, Dr. et al**
**Diehl Glaeser Hiltl & Partner,**
**Augustenstrasse 46**
**80333 München (DE)**

(54) **Teilchenoptische Vorrichtung und Verfahren zum Betrieb derselben**

(57) Es wird eine teilchenoptische Vorrichtung 25 und ein Verfahren zum Betrieb derselben vorgestellt. Die teilchenoptische Vorrichtung 25 stellt ein Magnetfeld zur Ablenkung von geladenen Teilchen eines Strahls 14 geladener Teilchen bereit und umfaßt einen von einem Stromleiter 47 wenigstens teilweise umgriffenen magnetflußführenden Körper 45 aus einem Material mit einer Permeabilitätszahl und eine Temperierungsvorrichtung 49, um eine Temperatur des magnetflußführenden Körpers im wesentlichen auf eine Soll-Temperatur einzustellen. Eine relative Schwankung der Permeabilitätszahl bezogen auf eine Breite eines Temperaturbereiches, soll dabei kleiner als ein Grenzwert a sein, wobei a bevorzugt kleiner als $3 \cdot 10^{-3}$ $K^{-1}$ ist. Insbesondere liegt die Soll-Temperatur bei einem Extremum einer Temperaturabhängigkeit der Permeabilitätszahl. Eine solche teilchenoptische Vorrichtung kann bevorzugt in einer Mikroskopie- oder einer Lithographievorrichtung eingesetzt werden.

Fig. 2

EP 1 398 817 A2

**Beschreibung**

Die vorliegende Erfindung betrifft eine teilchenoptische Vorrichtung zur Beeinflussung eines Strahls geladener Teilchen, ein Verfahren zum Betrieb einer solchen teilchenoptischen Vorrichtung, ein Mikroskopiesystem und ein Lithographiesystem.

Die teilchenoptische Vorrichtung stellt ein Magnetfeld bereit, welches von dem zu beeinflussenden Strahl durchsetzt wird, wobei die Beeinflussung eine Fokussierung, eine Ablenkung, eine Umformung des Strahls oder dergleichen umfassen kann.

Aus dem Stand der Technik sind Magnetfeldkonfigurationen bekannt, welche auf einen Strahl geladener Teilchen fokussierend, ablenkend oder umformend wirken.

Aus US 6, 188, 071 B1 ist beispielsweise ein Strahlablenker bekannt, welcher zum Einsatz in einem Lithographiesystem vorgesehen ist. Hierbei ist ein die Vorrichtung durchsetzender Strahl ein Elektronenstrahl, welcher als Schreibstrahl des Lithographiesystems eingesetzt wird. Eine Auflösung des hiermit durchgeführten Lithographieverfahrens ist damit mitbestimmt durch die Präzision, mit der die Ablenkung oder/und Fokussierung des Schreibstrahls in der Vorrichtung erfolgt. Die Vorrichtung umfaßt Ferritkörper zur Führung der durch Stromleiterwindungen erzeugten Magnetfelder. Ferritmaterialien haben die Eigenschaft, daß ihre magnetische Permeabilität eine Temperaturabhängigkeit aufweist. Ändert sich somit die Temperatur des Ferritkörpers, so wird sich auch seine magnetfeldführende Eigenschaft ändern, und es werden sich entsprechend die Wirkungen, die die Vorrichtung auf den diese durchsetzenden Schreibstahl ausübt, mit Temperaturschwankungen ändern. Gemäß US 6,188,071 B1 ist, um Temperatureinflüsse auf die Qualität der Lithographie zu mindern, eine Temperaturregelung vorgesehen, um die Temperatur des Ferritkörpers zu stabilisieren. Es wird in der Schrift auch erkannt, daß die Temperaturregelung unter Umständen zu träge sein kann, um Temperaturänderungen des Ferritkörpers in ausreichendem Maß zu unterdrücken. Deshalb weist die herkömmliche Vorrichtung eine zusätzliche Korrekturspule mit niedriger Induktivität auf, um durch die Temperaturregelung nicht unterdrückte Einflüsse der Temperaturabhängigkeit der Permeabilität des Ferritmaterials auf den Strahl aktiv zu kompensieren.

Es hat sich herausgestellt, daß der zur Unterdrückung von Temperatureinflüssen des Ferritmaterials zu treffende Aufwand erheblich ist, und es ist entsprechend eine Aufgabe der vorliegenden Erfindung, eine teilchenoptische Vorrichtung mit einem magnetflußführenden Körper, wie etwa einem Ferrit, vor zuschlagen, bei der Temperaturänderungen des magnetflußführenden Körpers geringere Auswirkungen auf einen durch die Vorrichtung zu beeinflussenden Strahl geladener Teilchen haben. Ferner ist es eine Aufgabe der Erfindung, ein Verfahren zum Betrieb einer solchen Vorrichtung vorzuschlagen. Eine weitere Aufgabe der Erfindung ist die Bereitstellung eines Elektronenmikroskopiesystems und/oder eines Lithographiesystems, bei denen vergleichsweise gute Abbildungseigenschaften erzielbar sind.

Die Erfindung geht aus von einer teilchenoptischen Vorrichtung zum Bereitstellen eines Magnetfeldes zur Beeinflussung eines Strahls geladener Teilchen, welche einen magnetflußführenden Körper aus einem Material mit einer großen Permeabilitätszahl, wenigstens einen den magnetflußführenden Körper wenigstens teilweise umgreifenden Stromleiter und eine Temperierungsvorrichtung umfaßt, um eine Temperatur des magnetflußführenden Körpers im wesentlichen auf eine Soll-Temperatur einzustellen.

Die Erfindung geht davon aus, daß die Permeabilitätszahl des magnetflußführenden Körpers grundsätzlich eine Temperaturabhängigkeit aufweist. Um Einflüsse von Temperaturänderungen des magnetflußführenden Körpers auf die Beeinflussung des Strahls zu verringern, ist entsprechend die Temperierungsvorrichtung vorgesehen, um den magnetflußführenden Körper im wesentlichen auf der Soll-Temperatur zu stabilisieren. Auch hier geht die Erfindung davon aus, daß eine solche Temperierungsvorrichtung, sei es als Steuerung oder als Regelung, Temperaturschwankungen des magnetflußführenden Körpers nicht perfekt verhindern kann. Hier setzt der der Erfindung zugrunde liegende Gedanke ein, nämlich die Soll-Temperatur des magnetflußführenden Körpers derart auszuwählen, daß diese in einem Temperaturbereich liegt, in dem sich die Permeabilitätszahl des Materials des magnetflußführenden Körpers vergleichsweise wenig ändert.

Treten in einem solchen Bereich Temperaturänderungen auf, so haben diese entsprechend einen vergleichsweise geringen Einfluß auf die Permeabilitätszahl und damit auf die Wirkung der teilchenoptischen Vorrichtung auf den diese durchsetzenden Strahl.

Ein Temperaturbereich, in dem sich die Permeabilitätszahl vergleichsweise wenig ändert, ist ein Bereich, in dem ein Graph, welcher die Abhängigkeit der Permeabilitätszahl von der Temperatur darstellt, eine vergleichsweise geringe Steigung aufweist. Entsprechend kann ein solcher Bereich charakterisiert werden durch folgende Formel:

$$\frac{\mu_{max} - \mu_{min}}{\mu_{max} \cdot \Delta T} = a;$$

wobei $a < 3 \cdot 10^{-3}\ K^{-1}$ ist.

Hierbei ist

$\mu_{max}$ ein Maximalwert der Permeabilitätszahl in dem Temperaturbereich,

$\mu_{min}$ ist ein Minimalwert der Permeabilitätszahl in dem Temperaturbereich und

ΔT ist eine Breite des Temperaturbereichs.

Im Hinblick auf eine besonders geringe Temperaturabhängigkeit der Permeabilität innerhalb des Temperaturbereichs, in dem sich die Soll-Temperatur unter Praxisbedingungen bewegt, wird a vorzugsweise gewählt zu a $< 9 \cdot 10^{-4}$ K$^{-1}$, bevorzugt a $< 3 \cdot 10^{-4}$ K$^{-1}$, stärker bevorzugt a $< 9 \cdot 10^{-5}$ K$^{-1}$, noch stärker bevorzugt a $< 3 \cdot 10^{-5}$ K$^{-1}$. Weiter bevorzugt sind noch kleinere Werte von a, nämlich a $< 9 \cdot 10^{-6}$ K$^{-1}$, insbesondere a $< 3 \cdot 10^{-6}$ K$^{-1}$ und noch stärker bevorzugt a $< 1 \cdot 10^{-6}$ K$^{-1}$.

Eine besonders gute Unabhängigkeit von Temperaturschwankungen wird dann erreicht, wenn die Soll-Temperatur derart eingestellt wird, daß dort die Temperaturabhängigkeit der Permeabilitätszahl des Materials des magnetflußführenden Körpers ein Extremum aufweist. Das Extremum kann ein Maximum oder ein Minimum sein.

Die Erfindung sieht eine Anwendung der vorangehend geschilderten teilchenoptischen Vorrichtung und deren Betriebsverfahren bevorzugt in einem Lithographiesystem oder/und einem Mikroskopiesystem.

Ausführungsformen der Erfindung werden nachfolgend anhand von Zeichnungen näher erläutert. Hierbei zeigt

Figur 1    ein Elektronenmikroskopiesystem gemäß einer Ausführungsform der Erfindung,

Figur 2    eine perspektivische aufgebrochene Darstellung eines Strahlablenkers gemäß einer Ausführungsform der Erfindung, welcher in dem Mikroskopiesystem der Figur 1 einsetzbar ist,

Figur 3    eine Draufsicht auf den in Figur 3 dargestellten Strahlablenker,

Figur 4    einen Graphen einer Temperaturabhängigkeit eines Ferritmaterials, welches in dem Strahlablenker gemäß Figuren 2 und 3 einsetzbar ist, und

Figur 5    ein Lithographiesystem gemäß einer Ausführungsform der Erfindung, in welchem die Strahlablenker gemäß Figuren 2 und 3 einsetzbar sind.

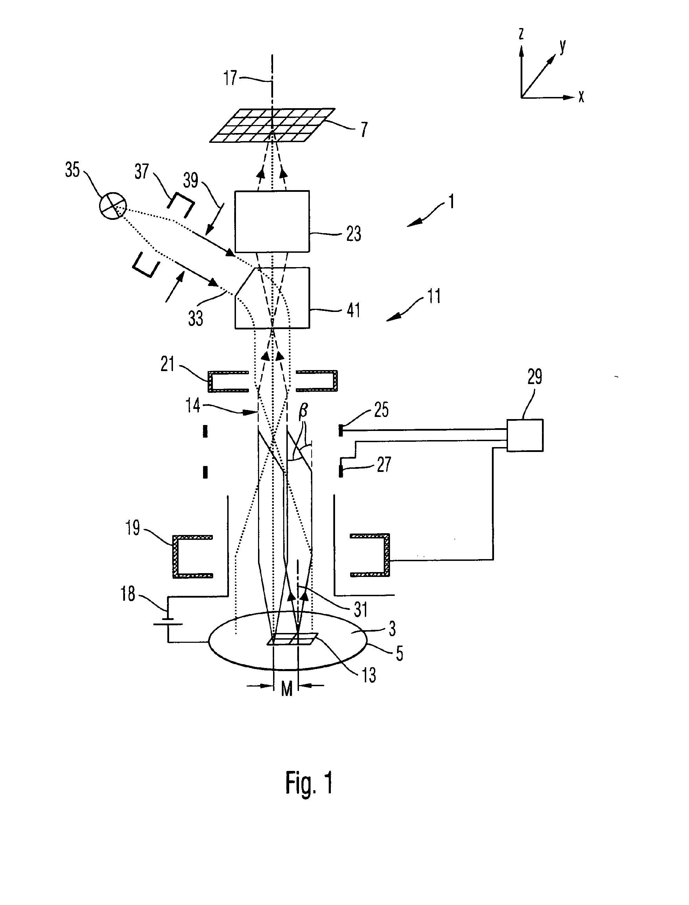

In Figur 1 ist ein Mikroskopiesystem 1 schematisch dargestellt, welches zur Abbildung eines in einer Objektebene 3 des Mikroskopiesystems 1 angeordneten Halbleiterwafers 5 auf einen ortsauflösenden Detektor 7 dient. Hierzu umfaßt das Mikroskopiesystem 1 eine Mikroskopieoptik 11, welche einen Strahlengang für Sekundärelektronen bereitstellt, um einen Bereich 13 der Objektebene 3 auf den Detektor 7 elektronenoptisch abzubilden. Hierbei ist der zur Abbildung des Bereiches 13, der auf den Detektor 7 abgebildet wird, eingesetzte Strahlengang parallel zu einer optischen Achse 17 des Mikroskopiesystems 1 auslenkbar (in Figur 1 ist eine Auslenkung mit M bezeichnet).

Hierzu umfaßt die Mikroskopieoptik 11 mehrere bezüglich der optischen Achse 17 zentriert angeordnete Komponenten, nämlich eine Objektivlinse 19, eine Feldlinse 21 und eine Nachvergrößerungsoptik 23. Zwischen der Objektivlinse 19 und Feldlinse 21 sind zwei mit Abstand entlang der optischen Achse 17 angeordnete Strahlablenker 25 und 27 vorgesehen, welche von einer Steuerung 29 angesteuert werden. Ein jeder der Strahlablenker 25, 27 bewirkt für den Sekundärelektronenstrahl 14 einen durch die Steuerung 29 einstellbaren Ablenkwinkel β, wobei allerdings die durch die beiden Strahlablenker 25, 27 bewirkten Ablenkwinkel einander entgegengesetzte Vorzeichen aufweisen. Somit durchsetzt der Sekundärelektronenstrahl 14 die beiden Linsen 19, 21 jeweils geradlinig, allerdings mit einem einstellbaren Versatz, parallel zur optischen Achse 17.

Die aus dem Halbleiterwafer 5 herausgeschlagenen Sekundärelektronen werden von einer Zugelektrode 18 parallel zur optischen Achse 17 beschleunigt.

Die Objektivlinse 19 stellt für den Sekundärelektronenstrahl 14 ein fokussierendes Feld bereit, dessen optische Achse 31 relativ zu der optischen Achse 17 der übrigen Komponenten verlagerbar ist. Die Steuerung 29 steuert die Objektivlinse 19 derart an, daß die optische Achse 31 der Objektivlinse 19 den auf den Detektor 7 abgebildeten Bereich 13 der Objektebene 3 zentral, senkrecht schneidet. Ein Beispiel für eine solche Objektivlinse ist in dem Artikel "MOL" ("Moving Objective Lense"), Optik 48 (1977), Seiten 255ff von E. Goto et al. oder in US 4,376,249 beschrieben. Ein weiteres Beispiel für eine solche Objektivlinse ist in der deutschen Patentanmeldung DE 101 61 526.4 und der nämlichen US-Nachanmeldung der Anmelderin beschrieben.

Die Sekundärelektronen werden aus dem Halbleiterwafer 5 ausgelöst durch einen Primärelektronenstrahl 33, welcher von einer Elektronenquelle 35 erzeugt wird, mit einer Kollimationslinse 37 kollimiert wird, durch eine Aperturblende 39 geformt wird und einem Strahlkombinator 41 zugeführt wird. Der Strahlkombinator 41 überlagert den Primärelektronenstrahl 33 mit dem Strahlengang des Sekundärelektronenstrahles 14. Auch der Primärelektronenstrahl 33 durchsetzt die Feldlinse 21, die Ablenker 25, 27 und die Objektivlinse 19. Auch der Primärelektronenstrahl 33 wird durch die Ablenker 25, 27 abgelenkt, allerdings nicht nötigerweise um exakt die gleichen Winkel wie der Sekundärelektronenstrahl 14. Allerdings ist es ausreichend, wenn der Primärelektronenstrahl 33 das Feld 13, welches auf den Detektor 7 abgebildet wird, lediglich einigermaßen homogen bestrahlt. Somit sind an die Abbildungseigenschaften des optischen Systems 11 für den Primärelektronenstrahl 33 geringere Anforderungen geknüpft als für den Sekundärelektronenstrahl 14.

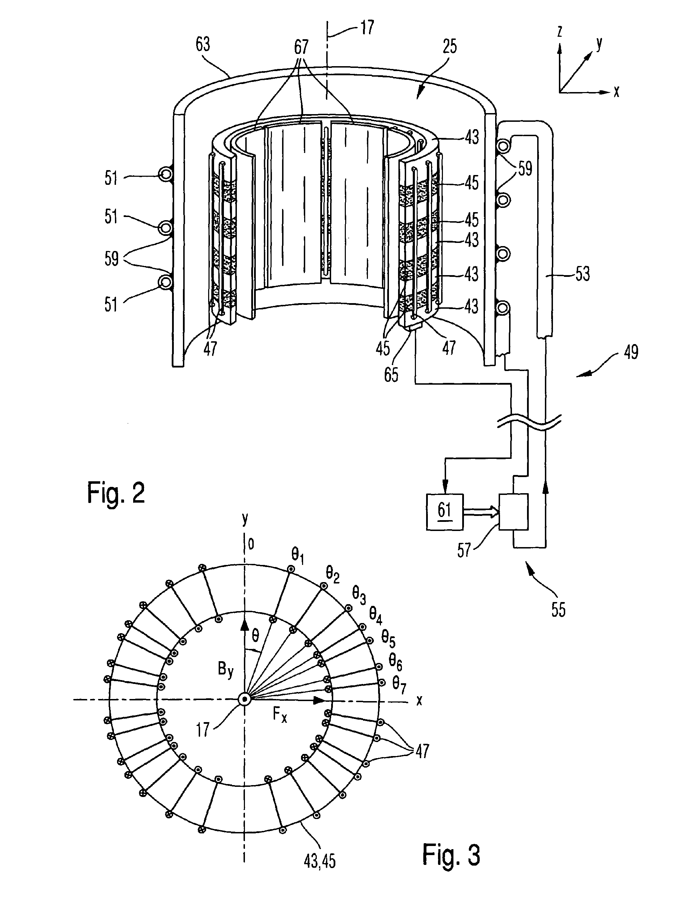

In Figur 2 ist der Ablenker 25 schematisch in perspektivischer aufgebrochener Darstellung gezeigt. Dieser umfaßt eine Mehrzahl konzentrisch zur optischen Achse 17 angeordneter Ringe 43 aus einem Material mit einer niedrigen Permeabilitätszahl sowie eine Mehrzahl von Ringen 45 aus einem Material mit einer hohen Permeabilitätszahl, welche zwischen benachbarten Ringen 43 aus dem Material mit der niedrigen Permeabilitätszahl angeordnet sind. Die Ringe 43, 45 sind somit als Stapel abwechselnd aufeinander angeordnet. Die Ringe 43, 45 werden von Stromleitern 47 umgriffen, welche sich im wesentlichen parallel zur optischen Achse 17 erstrecken und die den obersten und untersten Ring 43 radial durchsetzen.

In Figur 3 ist die Anordnung der Stromleiterwindungen in Umfangsrichtung um die optische Achse 17 dargestellt. Die in Figur 3 eingetragenen $\theta_1$ bis $\theta_7$ haben folgende Werte:

$\theta_1$=21,6°, $\theta_2$=41,6°, $\theta_3$=47,6°, $\theta_4$=62,4°, $\theta_5$=68,4°, $\theta_6$=78,5° und $\theta_7$=84,5°. Diese Winkel sind derart gewählt, daß das durch die Stromleiterwindungen 47 erzeugte Magnetfeld ein im wesentlichen homogenes in Y-Richtung orientiertes Magnetfeld ist.

Durch Erregen der Stromleiterwindungen 47 mit einem durch die Steuerung 29 eingestellten Strom ist es somit möglich, den Sekundärelektronenstrahl um einstellbare Winkel β in x-Richtung abzulenken.

Die Ringe 43 mit niedriger Permeabilitätszahl sind aus einem Macor® genannten Material gefertigt, welches von der Firma Corning, Inc., New York, USA bezogen werden kann.

Die Ringe 45 aus dem Material mit der hohen Permeabilitätszahl sind aus einem Mangan-Zink-Ferrit-Material gefertigt, welches von der Firma Ceramic Magnetics, Inc., New Jersey, USA unter der Produktbezeichnung MN-60 bezogen werden kann.

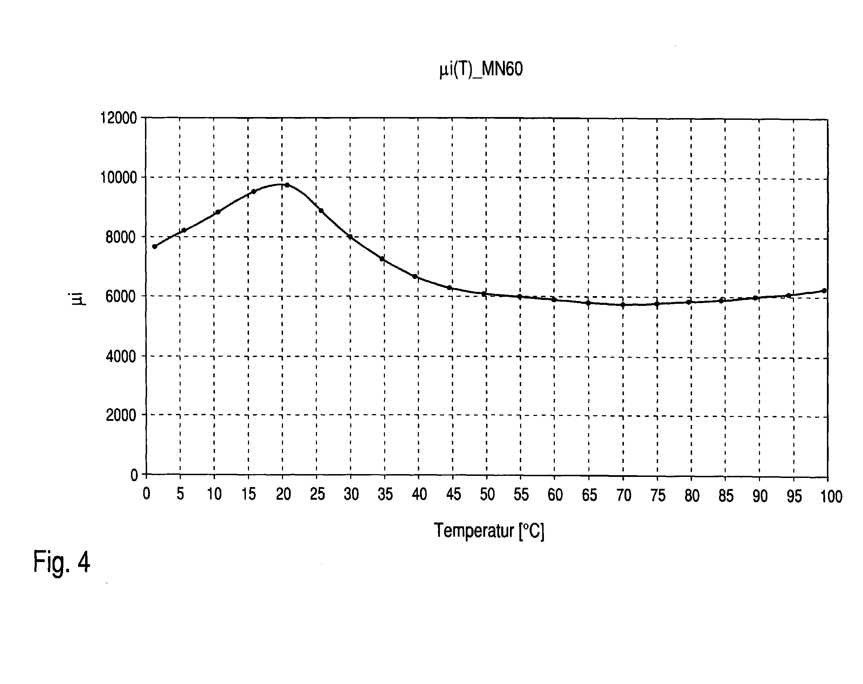

Die Permeabilitätszahl dieses Materials ist von der Temperatur abhängig. Ein Graph dieser Abhängigkeit ist für eine Probe aus diesem Material in Figur 4 dargestellt. Hieraus ist ersichtlich, daß die Permeabilitätszahl ein Maximum bei der Temperatur von etwa 20°C und ein Minimum bei der Temperatur von etwa 75°C aufweist. Bei einer Temperatur in einem Bereich von 25°C bis 40°C, in welchem Betriebstemperaturen für technische Vorrichtungen normalerweise liegen, weist die Temperaturabhängigkeit eine relativ große Steigung auf. Selbst wenn versucht wird, die Temperatur der Ringe 45 in diesem Bereich aktiv mittels einer Temperierungsvorrichtung zu stabilisieren, so führen unvermeidliche Schwankungen in der Temperatur dennoch zu gewissen Änderungen der Permeabilitätszahl der Ringe 45. Erfindungsgemäß ist deshalb vorgesehen, die Temperatur der Ringe 45 auf eine Soll-Temperatur einzustellen, welche in einem Temperaturbereich geringer Schwankungen der Permeabiltätszahl und welche insbesondere bevorzugt bei einem Extremum der Temperaturabhängigkeit der Permeabilitätszahl liegt, also entweder auf eine Temperatur von etwa 20°C oder auf eine Temperatur von etwa 75°C.

Hierzu ist eine in Figur 2 schematisch dargestellte Temperierungsvorrichtung 49 vorgesehen. Diese umfaßt mehrere Windungen 51 einer Rohrleitung 53, welche von einer Flüssigkeit, beispielsweise Wasser, durchflossen ist. Die Flüssigkeit durchfließt die Leitung 53 in einem geschlossenen Kreislauf 55, welcher eine Heiz/Kühlvorrichtung 57 durchsetzt, in der die die Leitung 53 durchfließende Flüssigkeit auf eine durch eine Steuerung 61 einstellbare Temperatur gebracht wird. Die Windungen 51 des Rohrs 53 liegen mit Wärmekontakt 59 an einem Strahlrohr 63 an, welches einen Vakuummantel für die Teilchenoptik 11 bereitstellt.

Der Strahlablenker 25 ist innerhalb des Strahlrohrs 63 in dem Bereich angeordnet, in dem auf das Strahlrohr 63 außen die Windungen 51 gewickelt sind. Somit ist es möglich, daß zwischen dem Strahlrohr 63 und dem Ablenker 25 ein Wärmeaustausch durch Wärmestrahlungsübertragung entsteht. Durch Einstellen der Temperatur des die Windungen 51 durchfließenden Mediums mittels der Heiz/Kühlvorrichtung 57 ist es somit möglich, die Temperatur der Ferritringe 45 des Strahlablenkers 25 in einem Bereich um die Soll-Temperatur einzustellen. Diese Einstellung erfolgt über einen Regelkreis, welcher einen an dem Stapel von Ringen 43, 45 angebrachten Sensor 65 umfaßt, der von der Steuerung 61 ausgelesen wird. Somit kann die Steuerung 61 eine Ist-Temperatur der Ringe 43, 45 mit deren Soll-Temperatur vergleichen und entsprechend auf die Temperatur des Mediums in den Windungen 51 über die Kühl/Heizvorrichtung 57 einwirken.

Bei der in Figur 2 dargestellten Temperierungsvorrichtung werden die Ferritringe 45 auf eine Soll-Temperatur von 20°C eingestellt, da dort das für die Ringe 45 verwendete Material ein Maximum der Permeabilitätszahl aufweist (vergleiche Figur 4). Alternativ hierzu ist es möglich, als Soll-Temperatur den Wert um 75°C zu wählen, wo die Permeabilitätszahl des für die Ringe 45 verwendeten Materials ein Minimum aufweist. Aus Figur 4 ist ersichtlich, daß bei dieser Temperatur das Extremum (Minimum) einen wesentlichen flacheren Verlauf aufweist als das Extremum (Maximum) bei der Temperatur von 20°C. Entsprechend ist die Permeabilitätszahl auch bei geringfügigen Änderungen um das Extremum bei der Soll-Temperatur von 75°C noch genauer zu halten als bei der Soll-Temperatur von 20°C. Anderseits ist bei dem Minimum bei höheren Temperatur von 75°C der Wert der Permeabilitätszahl deutlich geringer als bei dem Maximum bei 20°C, so daß die magnetische Wirkung der Ferritringe 45 bei dieser Temperatur entsprechend geringer ist.

Der Strahlablenker 25 umfaßt ferner Sektorelektroden 67, welche radial innerhalb der Ringe 43, 45 angeordnet sind. Diese stellen für den den Ablenker 25 durchsetzenden Strahl ein zusätzliches elektrisches Ablenkfeld bereit, welches dem durch die Stromleiter 47 bereitgestellten Magnetfeld überlagert ist. Somit lassen sich die Ablenker 25, 27 nach Art eines Wienfilters betreiben, und durch die Ablenker 25, 27 bewirkte Ablenkwinkel β lassen sich damit mit zusätzlichen Freiheitsgraden einstellen. Insbesondere können die für die Ablenkung bereitgestellten Magnetfelder und elektrischen Felder so eingestellt werden, daß für die Primärelektronen und die Sekundärelektronen sich im wesentlichen gleiche Ablenkwinkel β ergeben.

Die Stromleiter 47 werden derart erregt, daß der magnetische Fluß in den Ferritringen 45 unterhalb eines Sättigungswertes ist, so daß Änderungen in dem Magnetfeld eine im wesentlichen lineare Abhängigkeit von Änderungen eines Erregungsstromes aufweisen. Zum Beispiel kann ein in den Ferritringen 45 induzierter maximaler Fluß kleiner sein als 25 % eines Sättigungsflusses in diesem, oder insbesondere weniger als 15 % oder auch weniger als 10 % hiervon. Ferner kann der Erregungsstrom ein Wechselstrom sein, so daß eine Orientierung des magnetischen Flusses, der von den Ferritringen getragen wird, sich von Zeit zu zeit oder periodisch ändert.

Nachfolgend wird eine Variante der anhand der Figuren 1 bis 4 erläuterten Ausführungsform dargestellt. Hierbei tragen Komponenten, die hinsichtlich ihrer Funktion oder ihres Aufbaues Komponenten der Figuren 1 bis 4 entsprechen, jeweils gleiche Bezugsziffern, sind der besseren Unterscheidung halber jedoch mit einem zusätzlichen Buchstaben versehen. Es wird auf die gesamte vorangehende Beschreibung Bezug genommen.

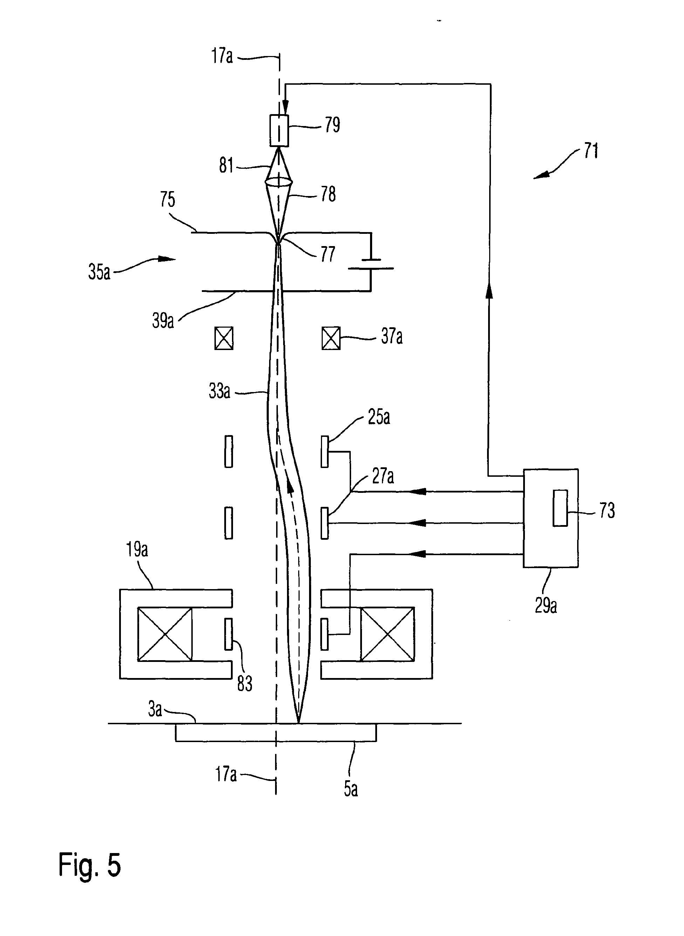

In Figur 5 ist ein Lithographiesystem 71 schematisch dargestellt. Dieses dient dazu, ein in einem Speicher 73 einer Steuerung 29a gespeichertes Muster auf einen teilchenempfindlichen Lack ("Resist") zu übertragen, mit welchem eine Oberfläche 3a eines Halbleiterwafers 5a in einem Lithographieverfahren zur Herstellung von miniaturisierten Halbleiterstrukturen beschichtet ist.

Die Übertragung des Musters erfolgt mittels eines Schreibelektronenstrahls 33a. Dieser wird von einer Elektronenquelle 35a erzeugt, welche eine Kathodenplatte 75 umfaßt, in welche eine Spitze 77 eingeprägt ist. Der Spitze 77 liegt eine Bohrung einer Aperturblende 39a gegenüber, welche gegenüber der Kathodenplatte 75 als Anode vorgespannt ist. Die Spitze 77 ist ferner auf einer optischen Achse 17a des Lithographiesystems 71 angeordnet und wird von oben von einem Laserstrahl 78 beleuchtet, welcher von einem Halbleiterlaser 79 erzeugt und einer Kollimationslinse 81 in die Spitze 77 kollimiert wird. Durch Ansteuern des Lasers 79 durch die Steuerung 29a ist es möglich, den Laserstrahl 78 schnell ein- und auszuschalten. Der Laserstrahl 78 unterstützt eine photonen-unterstützte Feldemission im Bereich der Spitze 77, durch welche aus der Spitze 77 Elektronen herausgezogen werden und durch die Aperturblende 39a beschleunigt werden, um den Schreibelektronenstrahl 33a zu formen, welcher nach Durchsetzen der Aperturblende 39a eine Kollimationslinse 37a durchläuft.

Durch die Kollimationslinse 37a wird der Schreibelektronenstrahl 33a zu einem sich entlang der optischen Achse 17a fortsetzenden im wesentlichen parallelen Strahl geformt. Dieser durchsetzt nacheinander zwei konzentrisch zur optischen Achse 17a angeordnete Ablenker 25a und 27a, woraufhin er in ein Objektiv 19a eintritt, welches ihn auf der Halbleiteroberfläche 3a bzw. der Objektebene des Lithographiesystems 71 fein fokussiert. Die Ablenker 25a und 27a weisen einen ähnlichen Aufbau auf, wie der anhand der Figuren 2 und 3 erläuterte Strahlablenker. In der Objektivlinse 19a ist ferner eine ebenfalls von der Steuerung 29a angesteuerte Spule 83 angeordnet, welche dem bezüglich der optischen Achse 17a rotationssymmetrischen fokussierenden Feld der Objektivlinse 19a ein Dipolfeld überlagert, um die optische Achse der Linsenwirkung des Objektives 19a aus der optischen Achse 17a derart zu verlagern, daß sie mit dem durch die Ablenker 25a, 27a aus der optischen Achse herausverlagerten Zentrum des Schreibelektronenstrahls 33a zusammenfällt. Auch die Ablenker 25a, 27a und die Spule 83 innerhalb des Lithographiesystems 71 können so aufgebaut sein, wie dies anhand der Figuren 2 und 3 erläutert wurde, wobei nicht unbedingt innerhalb des magnetischen Ablenkers bzw. der Spule Elektroden (Bezugszeichen 67 in Figur 2) angeordnet sind.

Die Steuerung 29a steuert somit zur Übertragung des in dem Speicher 73 gespeicherten Musters auf die Oberfläche 3a des Wafers 5a die Ablenker 25a, 27a und die Spule 83 sowie den Laser 79 derart an, daß der Schreibelektronenstrahl 33a auf eine gewünschte Weise über die Oberfläche 3a bewegt wird und hierbei nach Bedarf an- und ausgeschaltet wird.

Das Elektronenmikroskopiesystem, welches Anhand der Figur 1 erläutert wurde, bildet einen größeren Bereich der Objektoberfläche auf einen ortsauflösenden Detektor, beispielsweise einen CCD-Chip, ab. Ein solches Elektronenmikroskop wird üblicherweise als LEEM ("Low Energy Electron Microscope") oder SEEM ("Secondary Electron Emission Microscope") bezeichnet. Es ist jedoch auch möglich, den der Erfindung zugrunde liegenden Gedanken, d.h. die Stabilisierung eines magnetflußführenden Materials auf eine solche Temperatur, bei der dessen Temperaturabhängigkeit der Permeabilitätszahl gering ist bzw. ein Extremum aufweist, auf andere Typen von Elektronenmikroskopen übertragen werden. Ein Beispiel hierfür ist ein SEM ("Scanning Electron Microscope").

Das anhand der Figur 5 erläuterte Lithographiesystem ist ein "maskenloses" Lithographiesystem, bei dem der Schreibstrahl über eine Strahlquelle an- und ausgeschaltet wird. Es ist jedoch auch möglich, die Gedanken der Erfindung auf ein Lithographiesystem zu übertragen, bei dem eine Maske ("reticle") zur Definition des zu übertragenden Musters eingesetzt wird.

In den vorangehend erläuterten Ausführungsformen ist der auf eine entsprechend ausgewählte Soll-Temperatur stabilisierte magnetflußführende Körper in einer teilchenoptischen Vorrichtung angeordnet, welche als Strahlablenker dient. Es ist jedoch auch möglich, den magnetflußführenden Körper in anderen teilchenoptischen Vorrichtungen auf eine ausgewählte Temperatur zu bringen. Beispiele hierfür sind teilchenoptische Vorrichtungen, welche als Fokussierlinsen oder Korrekturelemente, wie etwa eine ein Hexapolfeld erzeugende Komponente oder dergleichen, wirken.

Andererseits kann, wenn eine Arbeitstemperatur einer teilchenoptischen Vorrichtung vorgegeben ist, ein Ferrit-Material geeignet gewählt werden. Die Temperaturabhängigkeit eines Ferritmaterials ist von dessen Zusammensetzung abhängig. Es wird daher bevorzugt ein Ferrit-Material eingesetzt oder entwickelt, welches in einem Temperaturbereich um die Arbeitstemperatur nur geringe Schwankungen der Permeabilität aufweist.

Das anhand der Figur 1 erläuterte Elektronenmikroskopiesystem und das anhand der Figur 5 erläuterte Lithographiesystem arbeiten mit jeweils einem Primärelektronenstrahl bzw. Schreibstrahl. Es ist jedoch auch möglich, in solchen Vorrichtungen mehrere Primärstrahlen bzw. Schreibstrahlen nebeneinander einzusetzen.

Zusammenfassend schlägt die Erfindung eine teilchenoptische Vorrichtung und ein Verfahren zum Betrieb vor, welche ein Magnetfeld zur Ablenkung von geladenen Teilchen eines Strahls geladener Teilchen bereitstellt und einen von einem Stromleiter wenigstens teilweise umgriffenen magnetflußführenden Körper aus einem Material mit einer Permeabilitätszahl und eine Temperierungsvorrichtung umfaßt, um eine Temperatur des magnetflußführenden Körpers im wesentlichen auf eine Soll-Temperatur einzustellen. Eine relative Schwankung der Permeabilitätszahl bezogen auf eine Breite eines Temperaturbereiches, soll dabei kleiner als ein Grenzwert a sein, wobei a bevorzugt kleiner als $3 \cdot 10^{-3} K^{-1}$ ist. Insbesondere liegt die Soll-Temperatur bei einem Extremum einer Temperaturabhängigkeit der Permeabilitätszahl. Eine solche teilchenoptische Vorrichtung kann bevorzugt in einer Mikroskopie- oder einer Lithographievorrichtung eingesetzt werden.

**Patentansprüche**

1. Teilchenoptische Vorrichtung (25, 27) zum Bereitstellen eines Magnetfeldes zum Beeinflussen von geladenen Teilchen eines Strahls (14) geladener Teilchen, wobei die Vorrichtung umfaßt:

   einen magnetflußführenden Körper (45) aus einem Material mit einer großen Permeabilitätszahl,

   wenigstens einen den magnetflußführenden Körper (45) wenigstens teilweise umgreifenden Stromleiter (47) und

   eine Temperierungsvorrichtung (49), um eine Temperatur des magnetflußführenden Körpers (45) im wesentlichen auf eine Soll-Temperatur einzustellen,

   wobei die Permeabilitätszahl des Materials eine Temperaturabhängigkeit aufweist und die Soll-Temperatur innerhalb eines Temperaturbereichs liegt, in dem gilt:

$$\frac{\mu_{max} - \mu_{min}}{\mu_{max} \cdot \Delta T} = a, \text{ mit } a < 3 \cdot 10^{-3} K^{-1}$$

   wobei

   $\mu_{max}$ ein Maximalwert der Permeabilitätszahl in dem Temperaturbereich ist,

   $\mu_{min}$ ein Minimalwert der Permeabilitätszahl in dem Temperaturbereich ist, und

   $\Delta T$ eine Breite des Temperaturbereichs ist.

2. Teilchenoptische Vorrichtung nach Anspruch 1, wobei gilt: $a < 9 \cdot 10^{-4} K^{-1}$, bevorzugt $a < 3 \cdot 10^{-4} K^{-1}$, stärker bevorzugt $a < 9 \cdot 10^{-5} K^{-1}$, noch stärker bevorzugt $a < 3 \cdot 10^{-5} K^{-1}$.

3. Teilchenoptische Vorrichtung nach einem der Ansprüche 1 oder 2, wobei gilt: $a < 9 \cdot 10^{-6} K^{-1}$, bevorzugt $a < 3 \cdot 10^{-6} K^{-1}$ und stärker bevorzugt $a < 1 \cdot 10^{-6} K^{-1}$.

4. Teilchenoptische Vorrichtung nach einem der Ansprüche 1 bis 3, wobei eine Temperaturabhängigkeit des Materials in dem Temperaturbereich ein Extremum aufweist.

5. Teilchenoptische Vorrichtung nach Anspruch 4, wobei die Soll-Temperatur eine Temperatur ist, bei der die Temperaturabhängigkeit das Extremum aufweist.

6. Teilchenoptische Vorrichtung nach einem der Ansprüche 1 bis 5, wobei die Temperierungsvorrichtung (49) einen Temperatursensor (65) zur Erfassung der Temperatur des magnetflußführenden Körpers (45) aufweist.

7. Teilchenoptische Vorrichtung nach einem der Ansprüche 1 bis 6, wobei das Material ein weichmagnetisches Material, insbesondere ein Ferrit-Material ist.

8. Teilchenoptische Vorrichtung nach einem der Ansprüche 1 bis 7, wobei die Permeabilitätszahl des Materials größer als 5000 ist, bevorzugt größer als 80000 ist und weiter bevorzugt größer als 10000 ist.

9. Verfahren zum Beeinflussen von geladenen Teilchen eines Strahls (14) geladener Teilchen durch ein Magnetfeld, wobei das Verfahren umfaßt:

Bereitstellen einer Magnetfelderzeugungsvorrichtung (25) mit einem magnetflußführenden Körper (45) aus einem Material mit einer großen Permeabilitätszahl ($\mu$) und wenigstens eines den magnetflußführenden Körper (45) wenigstens teilweise umgreifenden Stromleiters (47), und

Betreiben des magnetflußführenden Körpers (45) bei einer Arbeitstemperatur,

wobei die Permeabilitätszahl des Materials eine Temperaturabhängigkeit aufweist und das Material und die Arbeitstemperatur derart aufeinander abgestimmt sind, daß die Arbeitstemperatur innerhalb eines Temperaturbereichs liegt, in dem gilt:

$$\frac{\mu_{max} - \mu_{min}}{\mu_{max} \cdot \Delta T} = a. \text{ mit } a < 3 \cdot 10^{-3} K^{-1}$$

wobei

$\mu_{max}$ ein Maximalwert der Permeabilitätszahl in dem Temperaturbereich ist,

$\mu_{min}$ ein Minimalwert der Permeabilitätszahl in dem Temperaturbereich ist, und

$\Delta T$ eine Breite des Temperaturbereichs ist.

10. Verfahren nach Anspruch 9, wobei gilt: $a < 9 \cdot 10^{-4} K^{-1}$ , bevorzugt $a < 3 \cdot 10^{-4} K^{-1}$, stärker bevorzugt $a < 9 \cdot 10^{-5} K^{-1}$, noch stärker bevorzugt $a < 3 \cdot 10^{-5} K^{-1}$.

11. Verfahren nach Anspruch 9 oder 10, wobei eine Temperaturabhängigkeit des Materials in dem Temperaturbereich wenigstens ein Extremum aufweist.

12. Verfahren nach Anspruch 11, wobei die ArbeitsTemperatur eine Temperatur ist, bei der die Temperaturabhängigkeit ein Extremum aufweist.

13. Verfahren nach einem der Ansprüche 9 bis 12, wobei die Permeabilitätszahl des Materials größer als 5000, bevorzugt größer als 10000 ist.

14. Verfahren nach einem der Ansprüche 9 bis 13, wobei die Magnetfelderzeugungsvorrichtung (25) eine teilchenoptische Vorrichtung nach einem der Ansprüche 1 bis 7 umfaßt.

15. Lithographiesystem zur Übertragung eines Musters mittels wenigstens eines Schreibstrahls (33a) geladener Teilchen auf ein teilchenempfindliches Substrat (5a), wobei das Lithographiesystem wenigstens eine teilchenoptische Vorrichtung (25a, 27a) nach einem der Ansprüche 1 bis 8 umfaßt.

16. Mikroskopiesystem zur Untersuchung eines Objekts (5), wobei das Mikroskopiesystem wenigstens eine teilchenoptische Vorrichtung (25, 27) nach einem der Ansprüche 1 bis 8 umfaßt.

Fig. 1

EP 1 398 817 A2

Fig. 2

Fig. 3

9

Fig. 4

Fig. 5